# EUROPEAN PATENT SPECIFICATION

(11) **EP 2 810 999 B1**
(45) Date of publication and mention of the grant of the patent: **11.09.2019**
(21) Application number: 13761595.1
(22) Date of filing: 12.03.2013
(51) Int. Cl.: C09J 7/00

(54) **PRESSURE-SENSITIVE ADHESIVE COMPOSITION**
HAFTZUSAMMENSETZUNG
COMPOSITION ADHÉSIVE

(30) Priority: 12.03.2012 KR 20120025037
(43) Date of publication of application: 10.12.2014
(73) Proprietor: LG Chem, Ltd., Seoul 07336 (KR)
(72) Inventor: CHO, Yoon Gyung, Daejeon 305-380 (KR); CHANG, Suk Ky, Daejeon 305-380 (KR); YOO, Hyun Jee, Daejeon 305-380 (KR); SHIM, Jung Sup, Daejeon 302-380 (KR); LEE, Seung Min, Daejeon 305-380 (KR)
(74) Representative: Cabinet Plasseraud
(86) International application number: PCT/KR2013/001978
(87) International publication number: WO 2013/137621

(56) References cited:
- JP-A- 2008 244 095
- KR-A- 20040 039 274
- KR-A- 20090 080 956
- KR-A- 20110 007 166
- US-A1- 2003 060 555
- US-A1- 2006 122 312
- US-A1- 2007 117 926
- US-A1- 2007 295 446
- US-A1- 2010 089 636
- US-A1- 2011 036 497

## Description

### BACKGROUND

### 1. Field of the Invention

The present invention according to claims 1 to 17 relates to a pressure-sensitive adhesive composition, a pressure-sensitive adhesive film, and an organic electronic device.

### 2. Discussion of Related Art

A pressure-sensitive adhesive film may be used to protect an element or device sensitive to external factors such as moisture or oxygen. In the element or device which can be protected by the pressure-sensitive adhesive film, for example, an organic electronic device, a solar cell or a secondary battery such as a lithium secondary battery may be included. Particularly, among the elements or devices, the organic electronic device is vulnerable to external factors such as moisture and oxygen.

The organic electronic device is a device including a functional organic material. As the organic electronic device or an organic electronic element included in the organic electronic device, a photovoltaic device, a rectifier, a transmitter or an organic light emitting diode (OLED) may be used.

The organic electronic device is generally vulnerable to external factors such as moisture. For example, the OLED usually includes a functional organic material layer present between a pair of electrodes including a metal or metal oxide, and a layer of an organic material is peeled off from an interface with an electrode due to an effect of moisture from an external environment, a resistance value is increased by oxidizing an electrode due to the moisture, or the organic material is degenerated, thereby causing problems such as loss of an emissive function or decrease in luminescence. Accordingly, to protect the OLED from external environmental factors such as moisture, an encapsulating structure formed by covering the OLED formed on a substrate with a glass can or metal can equipped with a getter or moisture absorbent and fixing the resulting OLED with an adhesive is used.

US 2007/295446, US 2003/060555, US 2007/117926, US 2006/12231, US 2011/036497 and US 2010/089636 relates to adhesive compositions, also having barrier properties and based on the use of modified or not silica or clay particles.

### SUMMARY OF THE INVENTION

The present invention according to claims 1 to 17 is directed to providing a pressure-sensitive adhesive composition, a pressure-sensitive adhesive film and an organic electronic device.

One aspect of the present application provides a pressure-sensitive adhesive composition according to claims 1 to 7 and comprising: a binder resin; a nano clay modified with an organic modifier; and a solvent; wherein the nano clay modified with the organic modifier is comprised at 5 to 30 parts by weight relative to 100 parts by weight of the binder resin; and the binder resin is a polyisobutylene resin.

The polyisobutylene resin is a hydrophobic resin, which generally has a lower content of moisture and a lower water vapor transmission rate (WVTR) than other polymers.

The polyisobutylene resin may be, for example, a resin including a repeating unit of -[CH₂-C(CH₃)₂]ₙ- in a main or side chain. In one example, the polyisobutylene resin may be a homopolymer of isobutene. In addition, in another example, the polyisobutylene resin may be a copolymer of isobutene and a monomer capable of being copolymerized therewith. As the monomer capable of being copolymerized with isobutene, for example, 1-butene, 2-butene, isoprene or butadiene may be used.

For example, the binder resin may have a low glass transition temperature to be applied to the pressure-sensitive adhesive film. In one example, the binder resin may have a glass transition temperature of -90 to 20°C or -90 to -30 °C.

The binder resin may have a sufficient weight average molecular weight to be molded in the form of a film. In one example, a range of the weight average molecular weight at which molding in a film is possible may be approximately 50,000 to 2,000,000, 70,000 to 1,500,000 or 100,000 to 1,000,000. The term "weight average molecular weight" used herein refers to a conversion value with respect to standard polystyrene measured by gel permeation chromatography (GPC).

In addition, as the binder resin, one or at least two of the above components may be used. When at least two resins are used, the resins may be different in kind, weight average molecular weight or both.

Though the binder resin is a water-resistant resin, it is difficult to completely block moisture or vapor from an external environment. Accordingly, a nano clay may be combined with the binder resin, thereby maximizing a moisture blocking property.

The nano clay may be included in the pressure-sensitive adhesive composition, for example, as a moisture blocker. The term "moisture blocker" used herein may refer to a material which may have no or low reactivity with moisture penetrated from an outside, but which may block or interrupt flow of moisture or water.

As the nano clay, for example, a layered mineral may be used to extend a flow pathway of moisture from an external environment. In one example, the layered mineral may have a width of approximately 100 to 1000 nm, and a distance between layers of approximately 1 to 5 nm. Such a nano clay may have agglomeration between particles, and harmoniously exhibit enhanced durability and an enhanced moisture blocking property at a high temperature and high humidity due to mechanical properties of the mineral and transparency caused by dispersibility with a specific solvent.

The clay is a cation-substitutable mineral, which may be treated with an organic modifier for compatibility with the binder resin. In the specification, for convenience, the nano clay modified with an organic modifier is referred to as a nano clay. Here, the mineral may be modified with an organic modifier, and any mineral modifier known in the art may be used without limitation. The modifier may include, for example, an onium ion such as an ammonium ion containing an azo group or a peroxide group, a quaternary ammonium ion, or a phosphonium ion.

In one example, to maintain excellent transparency of the binder resin, the modified nano clay and a solvent may be suitably combined.

In one example, in the modified nano clay of the combination, as the nano clay, a layered silicate may be used. The layered silicate may be, for example, montmorillonite, saponite, hectorite, vermiculite, bentonite, attapulgite, sepiolite, halloysite or a mixture thereof.

In addition, in the modified nano clay of the combination, an organic modifier capable of modifying a nano clay may be, for example, one having a dimethyl benzyl hydrogenated tallow quaternary ammonium ion, a bis(hydrogenated tallow) dimethyl quaternary ammonium ion, a methyl tallow bis-2-hydroxyethyl quaternary ammonium ion, a dimethyl hydrogenated tallow 2-ethylhexyl quaternary ammonium ion or a dimethyl dehydrogenated tallow quaternary ammonium ion.

Such a modified nano clay may be combined with a specific solvent, thereby maintaining excellent transparency of the binder resin. The solvent may be selected in consideration of, for example, a refractive index, a volatility or a solubility parameter.

As the solvent, a solvent having a refractive index of, for example, 1.4 or more may be used. A solvent having a refractive index within the above range may be used to maintain excellent transparency of the binder resin. In addition, as the solvent, for example, a solvent having a boiling point of 70 to 200 °C or 80 to 150 °C may be used. Here, the solvent satisfying the above conditions may be at least one of n-propyl acetate, n-butyl acetate, cyclohexane, methylcyclohexane, benzene, toluene, ethylbenzene, xylene and 1,2,3-trimethylbenzene.

When the modified nano clay is combined with the binder resin, a moisture blocking property is enhanced. Particularly, when the above-described modified nano clay of the combination is combined with the solvent, a pressure-sensitive adhesive composition having an excellent moisture blocking property and transparency may be provided.

The modified nano clay is combined at 5 to 30 parts by weight, 5 to 25 parts by weight, 5 to 20 parts by weight, 10 to 30 parts by weight, 15 to 30 parts by weight, 10 to 25 parts by weight or 15 to 20 parts by weight relative to 100 parts by weight of the binder resin. In such a range, the transparency and the moisture blocking property of the pressure-sensitive adhesive composition may be maximized. In the specification, unless specifically defined otherwise, the unit "parts by weight" refers to a weight ratio.

The pressure-sensitive adhesive composition may be a non-curable or curable pressure-sensitive adhesive composition.

The non-curable pressure-sensitive adhesive composition may refer to a composition which may be adhered without a curing process. In one example, the non-curable pressure-sensitive adhesive composition may be adhered without exposure to heat and/or light, and thus suitable to be used to encapsulate an element sensitive to heat and/or light. Such a non-curable pressure-sensitive adhesive composition may include a binder resin not having a curable functional group, but the present application is not limited thereto. The binder resin having a curable functional group may also be used as long as the composition exhibits an adhesive property without a curing process. In one example, the binder resin not having a curable functional group may be a homopolymer of isobutene; or a copolymer of isobutene and normal butene.

A curable pressure-sensitive adhesive composition may refer to a composition which may be cured after being adhered to an adherent. To enhance physical properties such as processibility, a moisture blocking property and an adhesive property, a curable pressure-sensitive adhesive composition may be used. Such a curable pressure-sensitive adhesive composition may serve to encapsulate an element sensitive to heat and/or light by controlling a curing condition. In one example, the curable pressure-sensitive adhesive composition may include a binder resin having a curable functional group. The binder resin having a curable functional group may be a copolymer of the above-described isobutene monomer and a monomer such as isoprene or butadiene. In addition, in another example, the curable pressure-sensitive adhesive composition may further include a curable component. In this case, the binder resin may or may not include a curable functional group. The curable component may be any curable one known in the art without limitation. The curable component may be, for example, a multifunctional acrylate or an epoxy compound.

Here, the multifunctional acrylate may be any compound having at least two (meth)acryloyl groups without limitation. For example, the multifunctional acrylate may be a bifunctional acrylate such as 1,4-butanediol di(meth)acrylate, 1,6-hexanediol di(meth)acrylate, neopentylglycol di(meth)acrylate, polyethyleneglycol di(meth)acrylate, neopentylglycol adipate di(meth)acrylate, hydroxyl puivalic acid neopentylglycol di(meth)acrylate, dicyclopentanyl di(meth)acrylate, caprolactone-modified dicyclopentenyl di(meth)acrylate, ethyleneoxide-modified di(meth)acrylate, di(meth)acryloxy ethyl isocyanurate, allylated cyclohexyl di(meth)acrylate, tricyclodecanedimethanol(meth)acrylate, dimethylol dicyclopentane di(meth)acrylate, ethyleneoxide-modified hexahydrophthalic acid di(meth)acrylate, neopentylglycol-modified trimethylpropane di(meth)acrylate, adamantane di(meth)acrylate or 9,9-bis[4-(2-acryloyloxyethoxy)phenyl]fluorine; a trifunctional acrylate such as trimethylolpropane tri(meth)acrylate, dipentaerythritol tri(meth)acrylate, propionic acid-modified dipentaerythritol tri(meth)acrylate, pentaerythritol tri(meth)acrylate, propyleneoxide-modified trimethylolpropane tri(meth)acrylate, trifunctional urethane (meth)acrylate or tris(meth)acryloxyethylisocyanurate; a tetrafunctional acrylate such as diglycerine tetra(meth)acrylate or pentaerythritol tetra(meth)acrylate; a pentafunctional acrylate such as propionic acid-modified dipentaerythritol penta(meth)acrylate; or a hexafunctional acrylate such as dipentaerythritol, hexa(meth)acrylate, caprolactone-modified dipentaerythritol hexa(meth)acrylate or urethane (meth)acrylate (e.g., a product obtained by a reaction of an isocyanate monomer with trimethylolpropane tri(meth)acrylate); or a dendritic acrylate.

In addition, the multi-functional acrylate may include a ring structure in the molecule. The ring structure included in the multifunctional acrylate may be any one of a carbocyclic or heterocyclic structure; or a monocyclic or polycyclic structure. The multifunctional acrylate having a ring structure may be, but is not limited to, a hexafunctional acrylate such as a monomer having an isocyanurate structure such as tris(meth)acryloxy ethyl isocyanurate or isocyanate-modified urethane tri(meth)acrylate (e.g., a product obtained by a reaction of an isocyanate monomer with trimethylolpropane tri(meth)acrylate, etc.).

Here, the epoxy compound may be, for example, one or at least two of epoxylated linseed oil, epoxylated polybutadiene, polyisobutylene oxide, α-pinene oxide, limonene dioxide, 3,4-epoxycyclohexylmethyl-3,4-epoxycyclohexane carboxylate, tri-cyclodecane di-methanol diglycidyl ether, hydrogenated bisphenol A diglycidyl ether and 1,2-bis[(3-ethyl-3-oxetanyl methoxy)methyl]benzene.

The curable component may be used at 0.2 to 10 parts by weight relative to 100 parts by weight of the binder resin. In such a range, a pressure-sensitive adhesive composition capable of providing a pressure-sensitive adhesive film having a high moisture blocking property, and excellent mechanical properties and transparency may be provided.

The curable pressure-sensitive adhesive composition may further include an initiator. The initiator may be a radical initiator or a cationic initiator according to an exemplary embodiment.

A suitable free radical photoinitiator may be, but is not limited to, for example, an amino ketone such as 2-methyl-1-[4-(methylthio)phenyl]-2-(4-morpholinyl)-1-propanone or 2-benzyl-2-(dimethylamino)-1-[4-(4-morpholinyl)phenyl]-1-butanone; a benzoin ether such as benzoin methyl ether or benzoin isopropyl ether; a substituted benzoin ether such as anisoin methyl ether; a substituted acetophenone such as 2,2-diethoxyacetophenone or 2,2-dimethoxy-2-phenylacetophenone; a substituted α-ketole such as 2-methyl-2-hydroxypropionphenone; an aromatic phosphine oxide such as bis(2,4,6-trimethylbenzoyl)phenyl phosphine oxide; an aromatic sulfonyl chloride such as 2-naphthalene-sulfonyl chloride; a photoactive oxime such as 1-phenyl-1,2-propanedione-2(O-ethoxycarbonyl)oxime; or a mixture thereof.

A useful thermal free radical initiator may be, but is not limited to, an azo compound such as 2,2'-azo-bis(isobutyronitrile), dimethyl 2,2'-azo-bis(isobutyrate), azo-bis(diphenyl methane) or 4,4'-azo-bis(4-cyanopentanoic acid); a peroxide such as hydrogen peroxide, benzoyl peroxide, cumyl peroxide, tert-butyl peroxide, cyclohexanone peroxide, glutanic acid peroxide, lauroyl peroxide or methyl ethyl ketone peroxide; a hydroperoxide such as tert-butyl hydroperoxide or cumene hydroperoxide; a peroxy acid such as peracetic acid, perbenzoic acid, potassium persulfate or ammonium persulfate; a perester such as diisopropyl percarbonate; a thermal redox initiator; or a mixture thereof.

The cationic initiator may be an initiator known in the art. A useful cationic photoinitiator includes any one of various known useful materials, for example, an onium salt, a specific organic metal complex, or a mixture thereof. A useful onium salt includes a structural formula of AX. Here, A is selected from organic cations (e.g., selected from diazonium, iodonium and sulfonium cations; and particularly diphenyliodonium, triphenylsulfonium, and phenylthiophenyl diphenylsulfonium), and X is an anion (e.g., an organic sulfonate or a halogenated metal or metalloid). Particularly, the useful onium salt includes, but is not limited to, an aryl diazonium salt, a diaryl iodonium salt and a triaryl sulfonium salt. The useful cationic thermal initiator includes a quaternary ammonium salt of imidazole or a superacid (e.g., a quaternary ammonium salt of SbF₆), or a mixture thereof.

A ratio of the initiator is not particularly limited, and may be suitably selected according to a purpose. For example, the initiator may be included at 0.01 to 20 parts by weight relative to 100 parts by weight of the binder resin, but the present application is not limited thereto. When the ratio of the initiator is excessively low, suitable curing may not be induced, or when the ratio of the initiator is excessively high, physical properties may be degraded due to the initiator remaining after the pressure-sensitive adhesive layer or encapsulating layer is formed. Therefore, a suitable ratio may be selected.

The pressure-sensitive adhesive composition may further include a pressure-sensitive adhesive providing agent. Here, as the pressure-sensitive adhesive providing agent, for example, a hydrogenated petroleum resin obtained by hydrogenating a petroleum resin may be used. The hydrogenated petroleum resin may be partially or completely hydrogenated, or may be mixed with another hydrogenated petroleum resin. Such a pressure-sensitive adhesive providing agent may have good compatibility with the binder resin and an excellent moisture blocking property. The hydrogenated petroleum resin may be a hydrogenated terpene-based resin, a hydrogenated ester-based resin or a hydrogenated dicyclopentadiene-based resin. A weight average molecular weight of the pressure-sensitive adhesive providing agent may be approximately 200 to 5,000. A content of the pressure-sensitive adhesive providing agent may be suitably controlled as necessary. For example, the pressure-sensitive adhesive providing agent may be included in the pressure-sensitive adhesive composition at 5 to 100 parts by weight relative to 100 parts by weight of the binder resin. In addition, in consideration of laminating performance and performance of compensating step difference, a pressure-sensitive adhesive providing agent having a softening point of 70 to 150 °C may be used.

Various additives, in addition to the above-described components, may be included in the pressure-sensitive adhesive composition. As the additive, for example, a silane coupling agent, a leveling agent, a dispersing agent, an epoxy resin, a UV stabilizer, an antioxidant, a coloring agent, a reinforcing agent, a filler, a foaming agent, a surfactant or a plasticizer may be used.

As the silane coupling agent, any one known in the art may be used without limitation. For example, the silane coupling agent may be a silane coupling agent containing an epoxy group such as 3-glycidoxypropyl trimethoxysilane, 3-glycidoxypropyl triethoxysilane, 3-glycidoxypropylmethyl diethoxysilane, or 2-(3,4-epoxycyclohexyl)ethyl trimethoxysilane; a silane coupling agent containing an amino group such as 3-aminopropyl trimethoxy silane, N-2-(aminoethyl)-3-aminopropylmethyl dimethoxysilane or 3-triethoxysilyl-N-(1,3-dimethylbutylidene)propylamine; a silane coupling agent containing a (meth)acryl group such as 3-acryloxypropyl trimethoxysilane or 3-methacryloxypropyl triethoxysilane; a silane coupling agent containing a (meth)acryl group such as 3-isocyanatepropyl triethoxysilane; or a silane coupling agent containing an isocyanate group such as 3-isocyanatepropyl triethoxysilane.

The leveling agent may be used to planarize a pressure-sensitive adhesive resin when the pressure-sensitive adhesive composition is formed in the form of a film. As the leveling agent, for example, a silicon leveling agent, an acryl leveling agent or a fluorine-containing leveling agent may be used.

The dispersing agent may be any one known in the art without limitation. The dispersing agent may be selected in consideration of kinds of the nano clay and the binder resin. In one example, the dispersing agent may be a non-ionic surfactant. The non-ionic surfactant may be, for example, a saturated or unsaturated fatty acid having 4 to 28 carbon atoms such as stearic acid, palmitate, oleic acid or linoleic acid; a fatty alcohol such as cetyl alcohol, cetostearyl alcohol or oleyl alcohol; or a glucoside such as decyl glucoside, lauryl glucoside or octyl glucoside. Dispersion of the dispersing agent may be controlled by controlling a number of carbon atoms and content of an alkyl group. In one example, when the above-described dispersing agent is used, the dispersing agent may be used at 0.01 to 500 parts by weight relative to 100 parts by weight of the modified nano clay. In such a range, in the pressure-sensitive adhesive composition, the nano clay may be excellently dispersed in the pressure-sensitive adhesive resin, there is no problem caused by volatilization of the dispersing agent at a high temperature, and an excellent adhesive strength may be maintained.

In another embodiment of the present application, a pressure-sensitive adhesive film including a pressure-sensitive adhesive composition and a method of manufacturing the pressure-sensitive adhesive film are provided.

In one example, the pressure-sensitive adhesive film may include, for example, a pressure-sensitive adhesive layer including the pressure-sensitive adhesive composition in the form of a film.

The pressure-sensitive adhesive film may have an excellent moisture blocking property. The pressure-sensitive adhesive film has a very low content of moisture in the film itself since a water-resistant resin is used as a basic resin, and a very low WVTR with respect to moisture from an outside since a nano clay is included. In one example, the pressure-sensitive adhesive film may have a WVTR of less than 10 g/m²·day, 7.5 g/m²·day, 5 g/m²·day, 4 g/m²·day or 3.5 g/m²·day. The WVTR is measured with respect to the pressure-sensitive adhesive layer formed by drying the pressure-sensitive adhesive composition, coating the composition to have a thickness of 100 µm and drying the coated composition at 100 °F and a relative humidity of 100% in a thickness direction thereof. The WVTR may be measured according to ASTM F1249. As the WVTR is decreased, a more excellent moisture blocking property may be exhibited. However, the lower limit of the WVTR may be, but is not particularly limited to, for example, 0 g/m²·day or more.

The pressure-sensitive adhesive film may also have an excellent light transmittance in a visible light region. In one example, when the modified nano clay and the solvent are combined as described above, transparency of the binder resin may be excellently maintained. For example, the pressure-sensitive adhesive layer formed by drying the pressure-sensitive adhesive composition blended with a specific combination of the modified nano clay and the solvent, coating the composition to a thickness of 50 µm and drying the coated composition may have a light transmittance of 90%, 92%, 95%, 97% or 98% or more in the visible light region.

The pressure-sensitive adhesive film may have a low haze with the excellent light transmittance. In one example, when the modified nano clay and the solvent are combined as described above, the pressure-sensitive adhesive film having a low haze may be provided. For example, the pressure-sensitive adhesive layer formed under the same conditions for measuring the light transmittance may have a haze of less than 3%, 2.5%, or 2%.

The pressure-sensitive adhesive layer of the pressure-sensitive adhesive film may have a storage modulus of, for example, 10⁴ to 10⁷ Pa, 5 × 10⁴ to 10⁷ Pa, 10⁵ to 10⁷ Pa or 1.4 × 10⁵ to 10⁷ Pa at approximately 50 °C and a frequency of approximately 1 Hz. Under the above conditions, the pressure-sensitive adhesive film may have an excellent step difference compensating property and interface adhesive property. In one example, though the pressure-sensitive adhesive layer is attached to a surface on which an element sensitive to an external environment is formed, the pressure-sensitive adhesive layer may suitably compensate for a step difference between the element and the substrate, and have an excellent interface adhesive property in a part having the step difference.

In addition, the pressure-sensitive adhesive film may be a film having a low amount of volatilizing an organic component after formed to a final product. The pressure-sensitive adhesive film may have an amount of volatilizing an organic component of, for example, less than 1000 ppm at 150 °C for 1 hour. Though the pressure-sensitive adhesive layer having the above range of volatilizing amount is used to be in contact with an element which may be damaged by an organic component, durability and reliability may be excellently maintained at a high temperature and high humidity without damaging the element.

The pressure-sensitive adhesive film may exhibit excellent durability and reliability at a high temperature and/or high humidity, in addition to the above-described excellent physical properties.

A thickness of the pressure-sensitive adhesive layer may be suitably controlled according to a use, a location at which the pressure-sensitive adhesive film is applied and a structure of the pressure-sensitive adhesive film. For example, when the pressure-sensitive adhesive film is used to encapsulate an entire surface of the element sensitive to an external environment, the thickness of the pressure-sensitive adhesive layer may be controlled to approximately 5 to 100 µm.

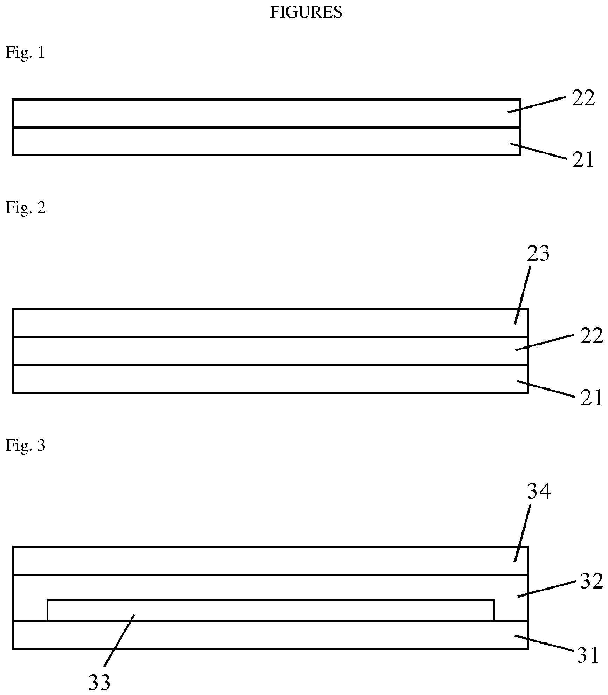

The pressure-sensitive adhesive film may further include a base film. Base films 21 and 23 may be present on one surface of the pressure-sensitive adhesive layer 22 as shown in FIG. 1, or on both surfaces of the pressure-sensitive adhesive layer 22 as shown in FIG. 2.

As the base film, a structure known in the art may be used without limitation. For example, a polyethyleneterephthalate film, a polytetrafluoroethylene film, a polyethylene film, a polypropylene film, a polybutene film, a polybutadiene film, a vinyl chloride copolymer film, a polyurethane film, an ethylene-vinyl acetate film, an ethylene-propylene copolymer film, an ethylene-acrylic acid ethyl copolymer film, an ethylene-acrylic acid methyl copolymer film or a polyamide film may be used.

Suitable releasing treatment may be performed on one or both surfaces of the base film as necessary. A method of release-treating the base film may be a method used in the art without limitation. For example, release treatment may be performed on one or both surfaces of the base film using an alkyde-, silicon-, fluorine-, unsaturated ester-, polyolefin- or wax-based compound.

The pressure-sensitive adhesive film may further include a gas barrier layer on one surface of the pressure-sensitive adhesive layer. A method of forming a gas barrier layer may be a method known in the art without limitation. In one example, the pressure-sensitive adhesive layer and the pressure-sensitive adhesive film having a gas barrier layer on one surface of the pressure-sensitive adhesive layer may be used to realize a flexible display.

The pressure-sensitive adhesive film may be prepared from the above-described pressure-sensitive adhesive composition.

The pressure-sensitive adhesive composition may be prepared by mixing a dispersion solution prepared by dispersing a nano clay modified with an organic modifier in a solvent with a solution including a binder resin.

In one example, before that, an operation of preparing a modified nano clay by optionally treating a nano clay with an organic modifier may be included. In this operation, suitable solvent and reaction conditions may be selected according to kinds of the nano clay and the organic modifier used. In addition, a ratio of the organic modifier may be controlled according to a kind thereof, and the organic modifier may be used at 10 to 100 parts by weight relative to 100 parts by weight of the nano clay. The nano clay and organic modifier used in this operation may be components, for example, corresponding to the above-described combination.

The dispersion solution may be prepared by mixing the modified nano clay prepared as described above with the solvent. The solvent used in this operation may be, for example, a solvent corresponding to the above-described combination. A content of the modified nano clay added to the solvent may be controlled in consideration of viscosity and dispersibility of the dispersion solution. In one example, the modified nano clay may be controlled to have a solid content of the dispersion solution of 1 wt% to 15 wt%, 1 wt% to 10 wt%, 3 wt% to 15 wt% or 3 wt% to 10 wt%. In this range, a pressure-sensitive adhesive composition having durability and reliability at a high temperature and/or high humidity, and suitable dispersibility and viscosity may be provided. After the modified nano clay is added to the solvent, a physical dispersing treatment method may be performed such that the clay may be uniformly dispersed in the solvent. As the physical dispersing treatment method, for example, a method of using a shaker, sonication, super high pressure dispersing treatment or bead milling may be used. In one example, when the modified nano clay has a layered structure, it may be dispersed in the solvent by sonication. Accordingly, the solvent may also be effectively dispersed between layers of the modified nano clay. The dispersion of the modified nano clay in the solvent may be performed for 5 to 200 minutes. In this range, a dispersion solution in which the modified nano clay is suitably dispersed may be obtained in an effective manufacturing process.

In one example, the dispersion solution including the modified nano clay may have a viscosity at room temperature of 100 mPa-s to 1000 mPa-s (100 cPs to 1000 cPs). The dispersion solution having a viscosity within this range may not include a by-product such as silver gel having a viscosity in the same range, and the pressure-sensitive adhesive film having excellent optical properties and durability at a high temperature and high humidity may be provided. The term "room temperature" used herein refers to a temperature in a natural state, which is not increased or decreased, and for example, approximately 15°C to 35°C, 20°C to 30°C or approximately 25 °C.

The dispersion solution prepared as described above may be mixed with a solution including a binder resin, thereby preparing the pressure-sensitive adhesive composition. In the solution including a binder resin, the above-described pressure-sensitive adhesive providing agent, a curable component, an initiator or an additive may be further included. In this operation, the dispersion solution may be added to the solution to have a solid content of the dispersion solution of 5 to 30, 5 to 25, 5 to 20, 10 to 30, 15 to 30, 10 to 25 or 15 to 20 parts by weight relative to 100 parts by weight of the binder resin. In such a range, a high moisture blocking property and transparency may be harmoniously exhibited, bubbles may not be generated at a high temperature and/or high humidity, and a pressure-sensitive adhesive composition having an excellent step difference compensating property may be provided. The pressure-sensitive adhesive composition may be diluted with a suitable solvent to have a solid content of approximately 10 to 40 wt% to ensure coatability. In one example, the same solvent as that used in the preparation of the dispersion solution may be used as the solvent. In addition, in another example, an auxiliary solvent may be used in consideration of coatability of the pressure-sensitive adhesive composition or an amount of volatilizing a solvent from the pressure-sensitive adhesive film. The auxiliary solvent may be, for example, at least one of the above solvents.

Here, the prepared pressure-sensitive adhesive composition may be prepared into a pressure-sensitive adhesive film through a coating operation. For example, the pressure-sensitive adhesive composition may be coated on the base film, thereby forming a film-shaped pressure-sensitive adhesive layer. The coating of the pressure-sensitive adhesive composition may be performed by a conventionally used method. For example, the pressure-sensitive adhesive composition may be coated by a known method such as knife coating, roll coating, spray coating, gravure coating, curtain coating, comma coating or lip coating. In addition, after the pressure-sensitive adhesive composition is coated, the solvent is dried and removed, thereby forming the pressure-sensitive adhesive layer. Here, drying conditions are not particularly limited, and for example, the drying may be performed at 20 to 200 °C for 1 to 20 minutes.

In addition, a pressure-sensitive adhesive film including base films on both surfaces may be manufactured by compressing an additional base film on a surface opposite to that of the pressure-sensitive adhesive layer on which the base film is present. Here, the operation of compressing the pressure-sensitive adhesive layer with the base film may be performed by a hot roll lamination or press process. Here, the operation may be performed by a hot roll lamination process at approximately 10 to 100 °C and approximately 0.1 to 10 kgf/cm² in terms of possibility and efficiency of a continuous process.

In addition, the pressure-sensitive adhesive film may be manufactured by forming a gas barrier layer on a surface opposite to that of the pressure-sensitive adhesive layer on which the base film is present. Here, a method of forming the gas barrier layer on one surface of the pressure-sensitive adhesive layer may be performed by a general method known in the art. In one example, the gas barrier layer may be formed using various materials having a moisture blocking property. As the material, for example, a fluorine-containing polymer of polyethylene trifluoride, or polychlorotrifluoroethylene (PCTFE); polyimide; polycarbonate; polyethylene terephthate; alicyclic polyolefin; or an ethylene-vinyl alcohol copolymer may be used. In another example, the gas barrier layer may be formed by a method of forming an inorganic thin film by sputtering silicon oxide, silicon nitride, aluminum oxide or diamond-like carbon as a material. In addition, the gas barrier layer may be composed of a stacked structure of the polymer layer and the inorganic thin film.

The pressure-sensitive adhesive film may be used in various uses in the field of an adhesive. In one example, the pressure-sensitive adhesive film may be used to encapsulate various targets to protect. Particularly, the film may be effective in protecting a target including an element sensitive to external components such as moisture and vapor. As an example of the target to which the pressure-sensitive adhesive film is applied, an organic electronic device such as a photovoltaic device, a rectifier, a transmitter or an organic light emitting diode (OLED); a solar cell; or a secondary battery may be used, but the present application is not limited thereto. The term "element" used herein may refer to any one of parts of an electronic device.

Another aspect of the present application provides an organic electronic device. The organic electronic device may include an organic electronic element and an encapsulating layer formed by encapsulating an entire surface of the element with a pressure-sensitive adhesive layer. In the specification, the pressure-sensitive adhesive layer and the encapsulating layer are terms referring to substantially the same components, and the pressure-sensitive adhesive layer included in the electronic device may be referred to as an encapsulating layer.

In one example, as shown in FIG. 3, the organic electronic device may include a lower substrate 31, an organic electronic element 33 formed on the lower substrate, an encapsulating layer 32 encapsulating an entire surface of the element, and an upper substrate 34 present on one surface of the encapsulating layer. In addition, in another example, the upper substrate 34 present on one surface of the encapsulating layer may be substituted with the above-described gas barrier layer. However, the present application is not limited thereto, and the electronic device may be changed to a structure used in the art.

As a representative example of the element which may be protected by the film, an organic electronic element such as an OLED may be used, but the present application is not limited thereto.

In one example, the encapsulating layer may be a pressure-sensitive adhesive layer of the above-described pressure-sensitive adhesive film. The above-described pressure-sensitive adhesive film may be attached without lifting or bubbles even on a surface having a height difference such as a substrate having the element due to an excellent step difference compensating property. As a result, an electronic device having an excellent surface adhesive strength between the encapsulating layer and the element or lower substrate may be provided.

In one example, when the pressure-sensitive adhesive composition including the pressure-sensitive adhesive film is a curable pressure-sensitive adhesive composition, the encapsulating layer may be cured after an entire surface of the element is encapsulated therewith. Here, curing conditions may be controlled in consideration of the kind of a component included in the curable pressure-sensitive adhesive composition within a range which does not damage the element.

The encapsulating layer may exhibit an excellent moisture blocking property and optical characteristics in the organic electronic device, and effectively fix and support the upper substrate with the lower substrate. In addition, the encapsulating layer may be formed to have excellent transparency and be stable whether the organic electronic device is a top emission or bottom emission type by modifying a nano clay using a specific combination of an organic modifier and a solvent and uniformly dispersing the modified nano clay in a resin.

The organic electronic device may be provided in a conventional configuration known in the art, except that the encapsulating layer is formed with the above-described film. For example, as the lower and upper substrate, a glass, metal or polymer film conventionally used in the art may be used. In addition, the organic electronic element may include, for example, a pair of electrodes, and an organic material layer formed between the pair of electrodes. Here, any one of the pair of electrodes may be a transparent electrode. In addition, the organic material layer may include, for example, a hole transport layer, an emitting layer and an electron transport layer.

### EFFECT

An exemplary pressure-sensitive adhesive composition can provide an encapsulating layer of a pressure-sensitive adhesive film and an organic electronic device, which exhibits an excellent moisture blocking property, transparency, durability and reliability at a high temperature and high humidity, step difference compensating property and adhesive strength.

### BRIEF DESCRIPTION OF THE DRAWINGS

FIGS. 1 and 2 illustrate schematic diagrams of exemplary pressure-sensitive adhesive films; and
FIG. 3 illustrates a schematic diagram of a cross-section of an exemplary organic electronic device.

### [Description of Reference Numerals]

21, 23: base film
22: pressure-sensitive adhesive
31: substrate
32: encapsulating layer
33: organic electronic element
34: substrate or gas barrier layer

### DETAILED DESCRIPTION OF EXEMPLARY EMBODIMENTS

Hereinafter, a pressure-sensitive adhesive composition will be described in further detail with reference to Example and Comparative Examples, but the scope of the composition is not limited to the following Examples.

Hereinafter, physical properties shown in Example and Comparative Examples were evaluated by the following methods.

### 1. Evaluation of transparency

A pressure-sensitive adhesive film was manufactured such that a pressure-sensitive adhesive layer was formed of a pressure-sensitive adhesive composition of Example or Comparative Example to have a thickness of approximately 50 µm. The pressure-sensitive adhesive layer of the manufactured pressure-sensitive adhesive film was transferred to a glass. Afterward, a light transmittance and a haze were measured based on glass using a haze meter (NDH-5000) according to a JIS K 7105 method.

### 2. Evaluation of moisture blocking property

A pressure-sensitive adhesive film was manufactured such that a pressure-sensitive adhesive layer was formed of a pressure-sensitive adhesive composition of Example or Comparative Example to have a thickness of approximately 100 µm. The pressure-sensitive adhesive layer was then laminated with a porous film, and a base film was peeled off, thereby preparing a sample. Afterward, while the sample was placed at 100 °F and a relative humidity of 100%, a WVTR of the sample in a thickness direction was measured. The WVTR was measured according to regulations of ASTM F1249.

### 3. Evaluation of storage modulus

A pressure-sensitive adhesive film was manufactured such that a pressure-sensitive adhesive layer was formed of a pressure-sensitive adhesive composition of Example or Comparative Example to have a thickness of approximately 500 µm, and base films were formed in a structure in which base films were present on both surfaces of the pressure-sensitive adhesive layer. A sample was prepared by cutting the manufactured pressure-sensitive adhesive film in a circular shape having a diameter of approximately 8 mm. Afterward, a storage modulus of the sample was measured at a frequency of 1 Hz and 50 °C by a temperature sweep method.

### 4. Durability and reliability at high temperature and high humidity

A pressure-sensitive adhesive film was manufactured such that a pressure-sensitive adhesive layer was formed of a pressure-sensitive adhesive composition of Example or Comparative Example to have a thickness of approximately 50 µm. A sample was prepared by attaching the pressure-sensitive adhesive layer of the prepared pressure-sensitive adhesive film to a glass. Afterward, while the sample was placed in a constant temperature and constant humidity chamber at 85 °C and a relative humidity of 85%, it was observed whether the generation of bubbles, change in turbidity and/or interface lifting occurred in the pressure-sensitive adhesive layer.

### 5. Evaluation of adhesive strength

A pressure-sensitive adhesive film was manufactured such that a pressure-sensitive adhesive layer was formed of a pressure-sensitive adhesive composition of Example or Comparative Example to have a thickness of approximately 50 µm. The manufactured pressure-sensitive adhesive layer was laminated with an unreleased PET base film, and then cut to have a width of 1 inch and a length of 20 cm. Subsequently, a specimen was prepared by peeling off the unreleased base film of the pressure-sensitive adhesive film, and transferring the pressure-sensitive adhesive layer to a glass. Afterward, a 180 degree adhesive strength of the sample was measured using a texture analyzer.

### Example 1

### (1) Preparation of pressure-sensitive adhesive composition

5 wt% of nano clay (trade name: Cloisite93A, Manufacturer: Southern Clay Products) modified with a bis(hydrogenated tallow) dimethyl quaternary ammonium ion was added to xylene, and mixed using an impeller. In addition, the resulting mixture was dispersed using an ultrasonicator for approximately 1 hour, thereby preparing a dispersion solution.

A polyisobutylene resin (weight average molecular weight: 1,000,000) was added to xylene to have a solid content of 10 wt%. Subsequently, a hydrogenated terpene resin (softening point: 100 °C) was added to the xylene at 40 parts by weight relative to 60 parts by weight of the polyisobutylene resin and mixed, thereby preparing a solution including a binder resin.

The prepared dispersion solution was added to the solution including the binding resin to have a solid content of the modified nano clay of 10 parts by weight relative to 100 parts by weight of the solution. Subsequently, the resulting solution was diluted and mixed with xylene to have a solid content of a final composition of 10 wt%, thereby preparing a pressure-sensitive adhesive composition.

### (2) Manufacture of pressure-sensitive adhesive film

The prepared pressure-sensitive adhesive composition was coated on a releasing PET base film using a bar coater. Subsequently, a pressure-sensitive adhesive film was manufactured by drying a layer of the coated pressure-sensitive adhesive composition in an oven at approximately 120 °C for approximately 30 minutes.

### Comparative Example 1

A pressure-sensitive adhesive composition and a pressure-sensitive adhesive film were manufactured as described in Example 1, except that un-modified nano clay was used instead of the nano clay modified with a bis(hydrogenated tallow) dimethyl quaternary ammonium ion.

### Comparative Example 2

A pressure-sensitive adhesive composition and a pressure-sensitive adhesive film were manufactured as described in Example 1, except that methylethylketone (MEK) was used in a dispersion solution instead of xylene.

### Comparative Example 3

A pressure-sensitive adhesive composition and a pressure-sensitive adhesive film were manufactured as described in Example 1, except that modified silica (Hydrophobic Fumed Silica, R972, Evonik) was used instead of the nano clay modified with a bis(hydrogenated tallow) dimethyl quaternary ammonium ion.

### Comparative Example 4

A pressure-sensitive adhesive composition and a pressure-sensitive adhesive film were manufactured as described in Example 1, except that a dispersion solution was not used.

**[Table 1]**

| | Example 1 | Comparative Example 1 | Comparative Example 2 | Comparative Example 3 | Comparative Example 4 |
|---|---|---|---|---|---|
| Light Transmittance (%) | 98 | 92 | 91 | 97 | 98 |
| Haze (%) | 1.6 | 9.8 | 10.7 | 3.9 | 0.3 |
| Moisture Blocking Property (g/m²·day) | 3.2 | 4.5 | 4.3 | 4.2 | 3.6 |
| Storage Modulus (Pa) | 1.5 x 10⁵ | 1.3 x 10⁵ | 1.2 x 10⁵ | 1.2 x 10⁵ | 0.8 x 10⁴ |
| Durability and Reliability | good | generation of bubbles | generation of bubbles | good | generation of bubbles |
| Adhesive Strength (g_{f}/inch) | 1450 | 1112 | 978 | 853 | 700 |

## Claims

1. A pressure-sensitive adhesive composition, comprising:
a binder resin;
a nano clay modified with an organic modifier; and
a solvent;
wherein the nano clay modified with the organic modifier is comprised at 5 to 30 parts by weight relative to 100 parts by weight of the binder resin; and
the binder resin is a polyisobutylene resin.

2. The composition of claim 1, wherein the nano clay is a layered silicate.

3. The composition of claim 1, wherein the organic modifier comprises a dimethyl benzyl hydrogenated tallow quaternary ammonium ion, a bis(hydrogenated tallow) dimethyl quaternary ammonium ion, a methyl tallow bis-2-hydroxyethyl quaternary ammonium ion, a dimethyl hydrogenated tallow 2-ethylhexyl quaternary ammonium ion or a dimethyl dehydrogenated tallow quaternary ammonium ion.

4. The composition of claim 1, wherein the solvent has a refractive index of 1.4 or more.

5. The composition of claim 4, wherein the solvent comprises n-propyl acetate, n-butyl acetate, cyclohexane, methylcyclohexane, benzene, toluene, ethylbenzene, xylene or 1,2,3-trimethylbenzene.

6. The composition of claim 1, further comprising:
a multifunctional acrylate or an epoxy compound.

7. The composition of claim 6, further comprising:
an initiator.

8. A pressure-sensitive adhesive film comprising the pressure-sensitive adhesive composition of claim 1.

9. The film of claim 8, which has a light transmittance of 90% or more in a visible light region as measured according to a JIS K 7105 method.

10. The film of claim 9, which has a haze of less than 3% as measured according to a JIS K 7105 method.

11. The film of claim 8, which has an amount of volatilizing an organic component of less than 1000 ppm at 150 °C for 1 hour.

12. A method of manufacturing a pressure-sensitive adhesive film, comprising:
preparing a pressure-sensitive adhesive composition by mixing a dispersion solution of a nano clay modified with an organic modifier and a solvent with a solution containing a binder resin; and
coating the pressure-sensitive adhesive composition on a base film;
wherein the binder resin is a polyisobutylene resin; and
the preparing of the pressure-sensitive adhesive composition comprises adding the dispersion solution to a solution including a binder resin to have a solid content of the dispersion solution of 5 to 30 parts by weight relative to 100 parts by weight of the binder resin.

13. The method of claim 12, further comprising:
preparing a nano clay modified with the organic modifier by treating the nano clay with the organic modifier before preparing the pressure-sensitive adhesive composition.

14. The method of claim 12, wherein the preparing of the pressure-sensitive adhesive composition comprises adding the nano clay modified with the organic modifier to the solvent to have a solid content of the dispersion solution of 1 to 15 wt%.

15. The method of claim 12, wherein the preparing of the pressure-sensitive adhesive composition comprises mixing the nano clay modified with the organic modifier with the solvent by a physical dispersion method.

16. The method of claim 12, wherein the preparing of the pressure-sensitive adhesive composition comprises mixing the nano clay modified with the organic modifier with the solvent after dispersion to have a viscosity at room temperature of 100 to 1000 mPa-s (100 to 1000 cPs).

17. An organic electronic device, comprising:
a substrate having an organic electronic element which is a photovoltaic device, a rectifier, a transmitter or an organic light emitting diode; and
an encapsulating layer encapsulating an entire surface of the organic electronic element and comprising the pressure-sensitive adhesive composition of claim 1.

## Patentansprüche

1. Druckempfindliche Klebstoffzusammensetzung, umfassend:
ein Bindemittelharz;
ein mit einem organischen Modifizierungsmittel modifiziertes Nanomineral;
und
ein Lösungsmittel;
wobei das mit einem organischen Modifizierungsmittel modifizierte Nanomineral 5 bis 30 Gewichtsteile bezogen auf 100 Gewichtsteile des Bindemittelharzes umfasst; und
das Bindemittelharz ein Polyisobutylen-Harz ist.

2. Zusammensetzung nach Anspruch 1, wobei das Nanomineral ein Schichtsilikat ist.

3. Zusammensetzung nach Anspruch 1, wobei das organische Modifizierungsmittel ein Dimethylbenzyl-hydrierter-Talg quartäres Ammoniumion, ein Bis(hydrierter Talg)dimethyl quartäres Ammoniumion, ein Methyltalg-bis-2-hydroxyethyl quartäres Ammoniumion, ein Dimethyl-hydrierter-Talg-2-ethylhexyl quartäres Ammoniumion oder ein Dimethyldehydrierter-Talg quartäres Ammoniumion umfasst.

4. Zusammensetzung nach Anspruch 1, wobei das Lösungsmittel einen Brechungsindex von 1,4 oder mehr hat.

5. Zusammensetzung nach Anspruch 4, wobei das Lösungsmittel n-Propylacetat, n-Butylacetat, Cyclohexan, Methylcyclohexan, Benzol, Toluol, Ethylbenzol, Xylol oder 1,2,3-Trimethylbenzol umfasst.

6. Zusammensetzung nach Anspruch 1, ferner umfassend:
ein multifunktionales Acrylat oder eine Epoxyverbindung.

7. Zusammensetzung nach Anspruch 6, ferner umfassend:
einen Initiator.

8. Druckempfindlicher Klebefilm umfassend die druckempfindliche Klebstoffzusammensetzung nach Anspruch 1.

9. Film nach Anspruch 8, der eine Lichtdurchlässigkeit von 90 % oder mehr in einem Bereich des sichtbaren Lichts, gemessen nach einer JIS K 7105 Methode, aufweist.

10. Film nach Anspruch 9, der eine Trübung von weniger als 3 %, gemessen nach einer JIS K 7105 Methode, aufweist.

11. Film nach Anspruch 8, der eine Menge einer flüchtigen organischen Komponente von weniger als 1000 ppm bei 150 °C für 1 Stunde aufweist.

12. Verfahren zur Herstellung eines druckempfindlichen Klebefilms, umfassend:
Herstellen einer druckempfindlichen Klebstoffzusammensetzung durch Mischen einer Dispersionslösung eines mit einem organischen Modifizierungsmittel modifizierten Nanominerals und einem Lösungsmittel mit einer Lösung, die ein Bindemittelharz enthält; und
Auftragen der druckempfindlichen Klebstoffzusammensetzung auf einen Basisfilm;
wobei das Bindemittelharz ein Polyisobutylen-Harz ist; und
das Herstellen der druckempfindlichen Klebstoffzusammensetzung das Zugeben der Dispersionslösung zu einer Lösung, die ein Bindemittelharz enthält, umfasst, um einen Feststoffgehalt der Dispersionslösung von 5 bis 30 Gewichtsteilen bezogen auf 100 Gewichtsteile des Bindemittelharzes zu erreichen.

13. Verfahren nach Anspruch 12, ferner umfassend:
Herstellen eines mit einem organischen Modifizierungsmittel modifizierten Nanominerals durch Behandeln des Nanominerals mit dem organischen Modifizierungsmittel vor dem Herstellen der druckempfindlichen Klebstoffzusammensetzung.

14. Verfahren nach Anspruch 12, wobei das Herstellen der druckempfindlichen Klebstoffzusammensetzung das Zugeben des mit dem organischen Modifizierungsmittel modifizierten Nanominerals zum Lösungsmittel umfasst, um einen Feststoffgehalt der Dispersionslösung von 1 bis 15 Gew.-% zu erreichen.

15. Verfahren nach Anspruch 12, wobei das Herstellen der druckempfindlichen Klebstoffzusammensetzung das Mischen des mit dem organischen Modifizierungsmittel modifizierten Nanominerals mit dem Lösungsmittel durch ein physikalisches Dispersionsverfahren umfasst.

16. Verfahren nach Anspruch 12, wobei das Herstellen der druckempfindlichen Klebstoffzusammensetzung das Mischen des mit dem organischen Modifizierungsmittel modifizierten Nanominerals mit dem Lösungsmittel umfasst, um nach Dispersion eine Viskosität bei Raumtemperatur von 100 bis 1000 mPa-s (100 bis 1000 cPs) zu erreichen.

17. Organische elektronische Vorrichtung, umfassend:
ein Substrat mit einem organischen elektronischen Element, das eine Photovoltaik-Vorrichtung, ein Gleichrichter, ein Sender oder eine organische Leuchtdiode ist; und
eine Einkapselungsschicht, die eine gesamte Oberfläche des organischen elektronischen Elements einkapselt und die druckempfindliche Klebstoffzusammensetzung nach Anspruch 1 umfasst.

## Revendications

1. Composition d'adhésif sensible à la pression, comprenant :
une résine liante ;
une nano-argile modifiée avec un modificateur organique ; et
un solvant ;
dans laquelle la nano-argile modifiée avec le modificateur organique est comprise à 5 à 30 parties en poids par rapport à 100 parties en poids de la résine liante ; et
la résine liante est une résine de polyisobutylène.

2. Composition selon la revendication 1, dans laquelle la nano-argile est un silicate en couches.

3. Composition selon la revendication 1, dans laquelle le modificateur organique comprend un ion de diméthylbenzyl suif hydrogéné ammonium quaternaire, un ion de bis(suif hydrogéné) diméthyl ammonium quaternaire, un ion de méthyl suif bis-2-hydroxyéthyl ammonium quaternaire, un ion de diméthyl suif hydrogéné 2-éthylhexyl ammonium quaternaire ou un ion de diméthyl suif déshydrogéné ammonium quaternaire.

4. Composition selon la revendication 1, dans laquelle le solvant présente un indice de réfraction de 1,4 ou plus.

5. Composition selon la revendication 4, dans laquelle le solvant comprend de l'acétate de n-propyle, de l'acétate de n-butyle, du cyclohexane, du méthylcyclohexane, du benzène, du toluène, de l'éthylbenzène, du xylène ou du 1,2,3-triméthylbenzène.

6. Composition selon la revendication 1, comprenant en outre :
un acrylate multifonctionnel ou un composé d'époxy.

7. Composition selon la revendication 6, comprenant en outre :
un initiateur.

8. Film adhésif sensible à la pression comprenant la composition d'adhésif sensible à la pression selon la revendication 1.

9. Film selon la revendication 8, qui présente un facteur de transmission de lumière de 90 % ou plus dans une région de lumière visible tel que mesuré selon un procédé JIS K 7105.

10. Film selon la revendication 9, qui présente un trouble de moins de 3 % tel que mesuré selon un procédé JIS K 7105.

11. Film selon la revendication 8, qui présente une quantité de volatilisation d'un composant organique de moins de 1000 ppm à 150 °C pendant 1 heure.

12. Procédé de fabrication d'un film adhésif sensible à la pression, comprenant :
la préparation d'une composition d'adhésif sensible à la pression par le mélange d'une solution de dispersion d'une nano-argile modifiée avec un modificateur organique et d'un solvant avec une solution contenant une résine liante ; et
le revêtement de la composition d'adhésif sensible à la pression sur un film de base ; dans lequel la résine liante est une résine de polyisobutylène ; et
la préparation de la composition d'adhésif sensible à la pression comprend l'ajout de la solution de dispersion à une solution incluant une résine liante pour avoir une teneur en solides de la solution de dispersion de 5 à 30 parties en poids par rapport à 100 parties en poids de la résine liante.

13. Procédé selon la revendication 12, comprenant en outre :
la préparation d'une nano-argile modifiée avec le modificateur organique par le traitement de la nano-argile avec le modificateur organique avant la préparation de la composition d'adhésif sensible à la pression.

14. Procédé selon la revendication 12, dans lequel la préparation de la composition d'adhésif sensible à la pression comprend l'ajout de la nano-argile modifiée avec le modificateur organique au solvant pour avoir une teneur en solides de la solution de dispersion de 1 à 15 % en poids.

15. Procédé selon la revendication 12, dans lequel la préparation de la composition d'adhésif sensible à la pression comprend le mélange de la nano-argile modifiée avec le modificateur organique avec le solvant par un procédé de dispersion physique.

16. Procédé selon la revendication 12, dans lequel la préparation de la composition d'adhésif sensible à la pression comprend le mélange de la nano-argile modifiée avec le modificateur organique avec le solvant après la dispersion pour avoir une viscosité à température ambiante de 100 à 1000 mPa-s (100 à 1000 cPs).

17. Dispositif électronique organique, comprenant :
un substrat ayant un élément électronique organique qui est un dispositif photovoltaïque, un redresseur, un émetteur ou une diode électroluminescente organique ; et
une couche d'encapsulation encapsulant une surface entière de l'élément électronique organique et comprenant la composition d'adhésif sensible à la pression selon la revendication 1.
